# EUROPÄISCHE PATENTSCHRIFT

(11) **EP 0 448 806 B1**
(45) Veröffentlichungstag und Bekanntmachung des Hinweises auf die Patenterteilung: **18.11.1993**
(21) Anmeldenummer: 90124152.1
(22) Anmeldetag: 13.12.1990
(51) Int. Cl.: H05K 7/20

(54) **Kühleinrichtung für Geräteeinschübe**
Cooling device for component drawers
Dispositif de refroidissement pour des tiroirs de composants

(30) Priorität: 29.03.1990 DE 9003687 U
(43) Veröffentlichungstag der Anmeldung: 02.10.1991
(73) Patentinhaber: SIEMENS AKTIENGESELLSCHAFT, 80333 München (DE)
(72) Erfinder: Baier, Josef, Ing., W-8000 München 71 (DE)

(56) Entgegenhaltungen:
- DE-B- 2 651 015
- FR-A- 2 605 481
- FR-A- 2 624 684
- GB-A- 1 491 570

## Beschreibung

Die Erfindung betrifft eine Kühleinrichtung für in ein Schrankgestell etagenweise übereinander einbaubare elektrische Geräteschübe, die eine Trägerplatte für wärmeerzeugende elektrische Bauelemente aufweisen, wobei die Trägerplatte durch innerhalb ihrer Wandung verlaufende Kühlkanäle für eine Kühlflüssigkeit gleichzeitig als Kühlkörper ausgebildet und mit einer Kupplungshälfte für den Zufluß und einer Kupplungshälfte für den Abfluß der Kühlflüssigkeit versehen ist und die jeweils andere Kupplungshälfte am Schrankgestell angeordnet ist und zusammen mit der betreffenden Kupplungshälfte der Trägerplatte jeweils eine beidseitig selbsttätig schließende Schnellverschlußkupplung bildet. Eine derartige Kühleinrichtung ist durch die DE-PS 26 51 015 bekannt.

In vielen Fällen ist bei Geräteeinschüben mit wärmeerzeugenden elektrischen Bauelementen eine Luftkühlung und/oder eine Entwärmung über am Einschub vorhandene Kühlrippen ausreichend. Für elektrische Geräteeinschübe mit sehr hohen Verlustleistungen läßt sich eine ausreichende Entwärmung aber nur mittels einer Flüssigkeitskühlung erreichen. Eine Flüssigkeitskühlung kann z.B. mit Hilfe eines Rohrsystems an der Rückseite von übereinandergestapelten, mit Leiterplatten für elektrische Bauelemente bestückten Gehäusen realisiert werden (DE-PS 34 17 986), wobei die Gehäuse mittels eines Steckanschlusses an das Rohrsystem angeschlossen werden. Bei der aus der DE-PS 26 51 015 bekannten Einrichtung ist ein als Einschub für ein Gestell ausgebildetes Chassis für einen elektrischen Leistungsverstärker vorgesehen, wobei die Kühlkanäle für die Kühlflüssigkeit innerhalb der Chassiswandung angeordnet und die Chassisplatte zum Anschluß an den Kühlflüssigkeitskreislauf mit Kupplungshälften einer Schnellverschlußkupplung versehen ist. Hierbei wird also die als Einschub ausgebildete Chassisplatte des elektrischen Leistungsverstärkers direkt gekühlt. Elektrische Geräteeinschübe sind aber oft nicht als Chassisplatte, sondern häufig als mit elektrischen Steckverbindungen versehene gehäuseartige Einschübe mit Frontplatte ausgebildet, wobei es immer häufiger vorkommt, daß an der Innenseite der Frontplatte des Geräteeinschubes wärmeerzeugende elektrische Bauelemente vorgesehen sind. In diesem Fall muß eine nicht nur wirksame, sondern auch praktikable und zuverlässige Flüssigkeitskühlung verschiedene Forderungen erfüllen:
a) Die Kühlflüssigkeit soll so nahe wie möglich an die wärmeerzeugenden elektrischen Bauelemente herangeführt werden,
b) der Kühlkreislauf soll gleichzeitig und gemeinsam mit den elektrischen Verbindungen hergestellt bzw. unterbrochen werden,
c) (feste und steckbare) Verbindungen im Kühlkreislauf sollen außerhalb eines HF-dichten Raumes erfolgen, in dem sich die elektrischen Baugruppen samt Rückverdrahtung befinden.

Der Erfindung liegt daher die Aufgabe zugrunde, eine Kühleinrichtung der eingangs genannten Art so auszubilden, daß sie bei Erfüllung der genannten Forderungen für Geräteeinschübe geeignet ist, welche mit elektrischen Steckverbindungen und mit einer elektrische Bauelemente tragenden Frontplatte versehen sind.

Diese Aufgabe wird bei einer Kühleinrichtung der eingangs genannten Art gemäß der Erfindung dadurch gelöst, daß die Trägerplatte für die wärmeerzeugenden elektrischen Bauelemente von einer seitlich über den Einbauraum eines Geräteeinschubes hinausragenden Frontplatte des Geräteeinschubes gebildet ist, daß die Kupplungshälften der Frontplatte in diesem seitlich über den Einbauraum hinausragenden Bereich angeordnet sind, und daß die am Schrankgestell vorgesehenen Kupplungshälften zusammen mit einem Rohrsystem in einem eigenen, abschließbaren Raum an einer Seite des Schrankgestells eingebaut und in Bezug auf die Kupplungshälften der Frontplatte so angeordnet sind, daß die Schnellverschlußkupplungen gleichzeitig mit der Herstellung oder Trennung von elektrischen Steckverbindungen der Geräteeinschübe im Schrankgestell verbindbar bzw. trennbar sind.

Eine derartige Kühleinrichtung gewährleistet eine wirksame, gut praktikable und zuverlässige Flüssigkeitskühlung von Geräteeinschüben, welche mit elektrischen Steckverbindungen sowie einer elektrische Bauelemente tragenden Frontplatte versehen und in ein Schrankgestell einbaubar sind, wobei der Kühlkreislauf gleichzeitig und gemeinsam mit den elektrischen Verbindungen hergestellt bzw. unterbrochen werden kann und die festen und steckbaren Verbindungen im Kühlkreislauf außerhalb des Einbauraumes der Geräteeinschübe im Schrankgestell angeordnet sind.

Vorteilhafte Ausgestaltungen des Gegenstandes des Anspruchs 1 sind in den Unteransprüchen angegeben.

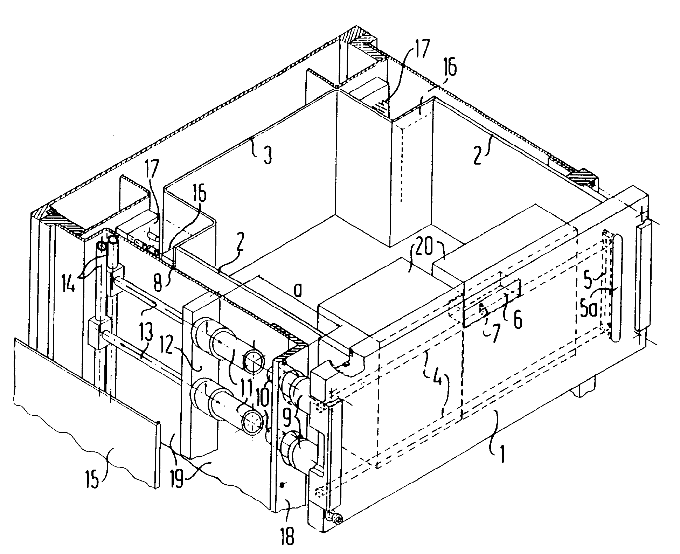

Ein Ausführungsbeispiel einer erfindungsgemäßen Kühleinrichtung ist im folgenden anhand der Zeichnung näher beschrieben.

In der einzigen Figur ist die Kühleinrichtung in perspektivischer Darstellung in einem Ausschnitt für einen in ein Schrankgestell einbaubaren Geräteeinschub gezeigt.

Der Geräteeinschub besteht im wesentlichen aus einer Frontplatte 1, zwei Seitenteilen 2 und einer Rückwand 3, deren elektrische Steckverbindungen 16 mit den elektrischen Steckverbindungen 17 des Schrankgestells zusammenwirken. Direkt auf der Rückseite, d.h. auf der Innenseite der Frontplatte 1, befinden sich wärmeerzeugende elektrische Bauelemente 20 mit sehr hohen Verlustleistungen, wie z.B. Übertrager, Transistoren, Dioden oder Thyristoren. Die Frontplatte 1 des Geräteeinschubes ragt seitlich über den Einbauraum des Geräteeinschubes hinaus und besteht aus einer z.B. etwa 15 mm dicken Aluminiumplatte, die mit zwei zueinander parallelen, sich nahezu über die gesamte Breite der Frontplatte horizontal verlaufenden Bohrungen 4 und mindestens einer Querverbindung versehen ist, welche hier von einer an einem Ende der Bohrungen 4 eingefrästen Nut 5 gebildet wird, deren Dichtigkeit durch ein im Vakuum aufgelötetes Aluminiumplättchen 5a gewährleistet ist. Die Bohrungen 4 und die Nut 5 bilden die innerhalb der Wandung der Frontplatte vorgesehenen Kühlkanäle für eine Kühlflüssigkeit. Eine luftgefüllte Kammer 6, die über eine Bohrung 7 von z.B. 1 mm im Durchmesser mit der oberen horizontalen Bohrung 4 verbunden ist, dient zum Druckausgleich bei Lagerung des Geräteeinschubes mit gefülltem Kühlsystem. Die horizontalen Bohrungen 4 der Frontplatte 1 sind an dem der Nut 5 gegenüberliegenden Ende über kurze, nicht näher dargestellte Querbohrungen mit jeweils einem als Steckerteil dienenden Rohrstück 9 und 10 verbunden, die beim Montieren auf der Frontplatte mit O-Ringen abgedichtet werden. Die Steckerteile 10 und die betreffenden, am Schrankgestell angeordneten Gegenstücke 11 sind Ventile, die beim Stecken eines Geräteeinschubes öffnen und beim Ziehen eines Geräteeinschubes selbsttätig schließen und den Kühlkreislauf unterbrechen. Die Steckerteile 10 und die Gegenstücke 11 bilden somit den Zufluß und den Abfluß der Kühlflüssigkeit zu bzw. von der Frontplatte ermöglichende Kupplungshälften einer Schnellverschlußkupplung. Derartige Flüssigkeitskupplungen sind an sich bekannt und handelsüblich, so daß sie hier nicht näher beschrieben zu werden brauchen.

Die Kupplungshälften 11 sind in X-Y-Richtung beweglich auf einer Schiene 12 angeordnet, die am Aufnahmerahmen 8 des Schrankgestells befestigt und auf ein solches Maß "a" in Bezug auf die Kupplungshälften 10 der Frontplatte 1 bzw. auf eine vordere, zur Befestigung der Frontplatte vorgesehene Stirnwand 18 des Schrankgestells eingestellt ist, daß die Herstellung oder Lösung der Kupplung gleichzeitig mit der Herstellung bzw. Trennung der elektrischen Steckverbindungen eines Geräteeinschubes erfolgt.

Zwei flexible Verbindungsstücke 13, die als Schlauch oder Wellrohr ausgeführt sind, verbinden die Kupplungshälften 11 mit vertikalen, z.B. aus Kupfer bestehenden Rohren 14 eines Rohrsystems, über welches die Kühlflüssigkeit für die einzelnen, etagenweise übereinander gestapelten Geräteeinschübe zu- bzw. abfließt.

Wie die einzige Figur deutlich zeigt, sind die am Schrankgestell angeordneten Kupplungshälften 11 zusammen mit den flexiblen Verbindungsstücken und dem Rohrsystem an einer Seite des Schrankgestells in einem eigenen Raum 19 vorgesehen, der mittels einer seitlichen Abdeckung 15 abgeschlossen ist. Diese Abdeckung schützt die Kühlflüssigkeitsverteiler vor Beschädigung. Die Anordnung des Rohrsystems in einem eigenen, abschließbaren Raum 19 ermöglicht eine von den Einbaugegebenheiten getrennte, unabhängige Zu- und Abführung der Kühlflüssigkeit zu den einzelnen Geräteeinschüben und verhindert, daß bei eventuellen Defekten austretende Flüssigkeit in den Innenraum des Schrankgestells gelangen kann.

## Patentansprüche

1. Kühleinrichtung für in ein Schrankgestell etagenweise übereinander einbaubare elektrische Geräteeinschübe, die eine Trägerplatte für wärmeerzeugende elektrische Bauelemente aufweisen, wobei die Trägerplatte durch innerhalb ihrer Wandung verlaufende Kühlkanäle für eine Kühlflüssigkeit gleichzeitig als Kühlkörper ausgebildet und mit einer Kupplungshälfte für den Zufluß und einer Kupplungshälfte für den Abfluß der Kühlflüssigkeit versehen ist und die jeweils andere Kupplungshälfte am Schrankgestell angeordnet ist und zusammen mit der betreffenden Kupplungshälfte der Trägerplatte jeweils eine beidseitig selbsttätig schließende Schnellverschlußkupplung bildet,
**dadurch gekennzeichnet**, daß die Trägerplatte für die wärmeerzeugenden elektrischen Bauelemente von einer seitlich über den Einbauraum eines Geräteeinschubes hinausragenden Frontplatte (1) des Geräteeinschubes gebildet ist, daß die Kupplungshälften (9,10) der Frontplatte (1) in diesem seitlich über den Einbauraum hinausragenden Bereich angeordnet sind, und daß die am Schrankgestell (8) vorgesehenen Kupplungshälften (11) zusammen mit einem Rohrsystem (13,14) in einem eigenen, abschließbaren Raum (19) an einer Seite des Schrankgestells eingebaut und in Bezug auf die Kupplungshälften (9,10) der Frontplatte (1) so angeordnet sind, daß die Schnellverschlußkupplungen gleichzeitig mit der Herstellung oder Trennung von elektrischen Steckverbindungen der Geräteeinschübe im Schrankgestell verbindbar bzw. trennbar sind.

2. Kühleinrichtung nach Anspruch 1,
**dadurch gekennzeichnet**, daß die Kühlkanäle in der Frontplatte (1) aus zwei sich nahezu über die gesamte Breite der Frontplatte horizontal erstreckenden, zueinander parallelen Bohrungen (4) und mindestens einer Querverbindung (5) bestehen.

3. Kühleinrichtung nach Anspruch 2,
**dadurch gekennzeichnet**, daß die Querverbindung (5) von einer an einem Ende der Bohrungen (4) eingefrästen, nach außen dicht verschlossenen Nut gebildet ist.

4. Kühleinrichtung nach einem der Ansprüche 2 oder 3,
**dadurch gekennzeichnet**, daß die Frontplatte (1) mit einer luftgefüllten, mit der oberen der beiden horizontalen Bohrungen (4) verbundenen Kammer (6) ausgebildet ist.

5. Kühleinrichtung nach einem der Ansprüche 2 bis 4,
**dadurch gekennzeichnet**, daß die horizontalen Bohrungen (4) an dem der Querverbindung (5) gegenüberliegenden Ende über kurze Querbohrungen mit der jeweiligen Kupplungshälfte (9,10) verbunden sind.

6. Kühleinrichtung nach einem der vorhergehenden Ansprüche,
**dadurch gekennzeichnet**, daß die Kupplungshälften (11) im Schrankgestell in X-Y-Richtung beweglich auf einer Schiene (12) angeordnet sind.

7. Kühleinrichtung nach einem der vorhergehenden Ansprüche,
**dadurch gekennzeichnet**, daß die Kupplungshälften (11) im Schrankgestell über flexible Verbindungsstücke (13) mit vertikalen Rohren (14) des Rohrsystems verbunden sind.

## Claims

1. Cooling system for electrical withdrawable units which can be installed one above another in tiers in a cabinet frame and have a carrier plate for heat-generating electrical components, the carrier plate simultaneously being constructed as a heat sink by means of cooling ducts, extending inside its wall, for a cooling liquid, and being provided with one coupling half for the inflow of the cooling liquid and one coupling half for the discharge of the cooling liquid, and the respective other coupling half being arranged on the cabinet frame and in each case forming, together with the relevant coupling half of the carrier plate, a quick-release lock coupling which closes automatically on both sides, characterised in that the carrier plate for the heat-generating electrical components is formed by a front panel (1) of a withdrawable unit which projects laterally over the installation space of a withdrawable unit, in that the coupling halves (9, 10) of the front panel (1) are arranged in this region projecting laterally over the installation space, and in that the coupling halves (11) provided on the cabinet frame (8) are installed together with a pipe system (13, 14) in a dedicated, sealable space (19) on one side of the cabinet frame and are arranged with respect to the coupling halves (9, 10) of the front panel (1) such that the quick-release lock couplings can be connected or separated in the cabinet frame simultaneously with the making-or breaking of electrical plug-in connections of the withdrawable units.

2. Cooling system according to Claim 1, characterised in that the cooling ducts in the front panel (1) comprise two mutually parallel bores (4) which extend horizontally virtually over the entire width of the front panel, and at least one transverse connection (5).

3. Cooling system according to Claim 2, characterised in that the transverse connection (5) is formed by a groove milled in at one end of the bores (4) and sealed in a leakproof fashion to the outside.

4. Cooling system according to one of Claims 2 or 3, characterised in that the front panel (1) is constructed with a chamber (6) which is filled with air and connected to the upper of the two horizontal bores (4).

5. Cooling system according to one of Claims 2 to 4, characterised in that at the end opposite the transverse connection (5), the horizontal bores (4) are connected via short transverse bores to the respective coupling half (9, 10).

6. Cooling system according to one of the preceding claims, characterised in that the coupling halves (11) are arranged movably in the X-Y direction on a rail (12) in the cabinet frame.

7. Cooling system according to one of the preceding claims, characterised in that the coupling halves (11) are connected in the cabinet frame to vertical pipes (14) of the pipe system via flexible connecting pieces (13).

## Revendications

1. Dispositif de refroidissement pour des tiroirs électriques d'appareils, qui doivent être insérés d'une manière superposée selon des étages dans un bâti d'armoire et qui comportent une plaque de support pour des composants électriques dégageant de la chaleur, et dans lequel la plaque de support est réalisée simultanément sous la forme d'un dissipateur de chaleur grâce à la présence de canaux de refroidissement ménagés dans sa paroi pour la circulation d'un liquide de refroidissement, et est pourvue d'une moitié d'accouplement pour l'amenée du liquide de refroidissement et d'une moitié d'accouplement pour l'évacuation de ce liquide et dans lequel respectivement l'autre moitié d'accouplement est montée sur le bâti d'armoire et forme, conjointement avec la moitié d'accouplement concernée de la plaque de support, respectivement un accouplement à fermeture rapide, qui se ferme automatiquement des deux côtés, caractérisé par le fait que la plaque de support pour les composants électriques dégageant de la chaleur est formée par une plaque avant (1) du tiroir d'appareil, qui fait saillie latéralement au-delà de l'espace de montage de ce tiroir, que les moitiés d'accouplement (9,10) de la plaque avant (1) sont disposées dans cette zone qui s'étend latéralement au-delà de l'espace de montage, et que les moitiés d'accouplement (11) prévues sur le bâti d'armoire (8) sont montées, conjointement avec un système de tubes (13,14), dans un espace particulier (19), pouvant être fermé, sur un côté du bâti de l'armoire et sont disposés par rapport aux moitiés d'accouplement (9,10) de la plaque avant (1) de telle sorte que les accouplements de fermeture rapide peuvent être réunis ou séparés simultanément lors de l'établissement ou de la séparation de liaisons électriques à enfichage des tiroirs d'appareils dans le bâti de l'armoire.

2. Dispositif de refroidissement suivant la revendication 1, caractérisé par le fait que les canaux de refroidissement ménagés dans la plaque avant (1) sont constitués par deux perçages parallèles (4), qui s'étendent horizontalement approximativement sur toute la largeur de la plaque avant, et par au moins une liaison transversale (5).

3. Dispositif de refroidissement suivant la revendication 2, caractérisé par le fait que la liaison transversale (5) est formée par une rainure formée par fraisage à une extrémité des perçages (4) et est fermée de façon étanche en direction de l'extérieur.

4. Dispositif de refroidissement suivant l'une des revendications 2 ou 3, caractérisé par le fait que la plaque avant (1) comporte une chambre remplie d'air (6), qui est raccordée au perçage supérieur parmi les deux perçages horizontaux (4).

5. Dispositif de refroidissement suivant l'une des revendications 2 à 4, caractérisé par le fait que les perçages horizontaux (4) sont raccordés, à l'extrémité opposée à la liaison transversale (5), à la moitié respective d'accouplement (9,10) par l'intermédiaire de courts perçages transversaux.

6. Dispositif de refroidissement suivant l'une des revendications précédentes, caractérisé par le fait que les moitiés d'accouplement (11) sont disposées dans le bâti de l'armoire de manière à être déplaçables suivant la direction X-Y sur un rail (12).

7. Dispositif de refroidissement suivant l'une des revendications précédentes, caractérisé par le fait que les moitiés d'accouplement (11) sont reliées, dans le bâti de l'armoire, à des tubes verticaux (14) du système de tubes, par l'intermédiaire d'éléments flexibles de raccordement (13).
